# EUROPÄISCHE PATENTSCHRIFT

(11) **EP 0 590 349 B1**
(45) Veröffentlichungstag und Bekanntmachung des Hinweises auf die Patenterteilung: **25.03.1998**
(21) Anmeldenummer: 93114161.8
(22) Anmeldetag: 03.09.1993
(51) Int. Cl.: G01V 3/10, G01R 33/022

(54) **Magnetometersonde**
Magnetometer probe
Sonde de magnétomètre

(30) Priorität: 28.09.1992 DE 4232466
(43) Veröffentlichungstag der Anmeldung: 06.04.1994
(73) Patentinhaber: Ebinger, Klaus, D-51149 Köln (DE)
(72) Erfinder: Ebinger, Klaus, D-51149 Köln (DE)
(74) Vertreter: Heim, Hans-Karl, Dipl.-Ing.

(56) Entgegenhaltungen:
- DE-A- 2 929 404
- DE-B- 2 525 751
- DE-U- 9 213 051
- GB-A- 2 078 968
- US-A- 2 996 663
- US-A- 3 757 209
- US-A- 3 961 245

## Beschreibung

Die Erfindung betrifft eine Magnetometersonde mit einer Anordnung aus einem rohrförmigen Sondengehäuse, in dem voneinander beabstandet und im wesentlichen koaxial zum Sondengehäuse zwei magnetische Induktoren angeordnet sind, von denen ein erster Induktor um eine quer zur Achse des Sondengehäuses gelegene Schwenkachse schwenkbar gelagert ist.

Es ist eine Vielzahl von Magnetometersonden bekannt, die entweder zum Suchen und Orten von Eisenteilen im Erdboden oder auch für geophysikalische Magnetfeldvermessungen eingesetzt werden.

Zur Lösung typischer Suchaufgaben im Erdboden oder Gewässer haben sich sog. Saturationsmagnetometer in der Art eines Feldstärke-Differenzmessers durchgesetzt. Grundlage einer derartigen Magnetometersonde bilden zwei magnetempfindliche Induktoren, die koaxial und mit vorgegebenem Basisabstand in einem Suchrohr von etwa 500 bis 600 mm Länge angeordnet sind.

Beide Induktoren einer derartigen Suchanordnung sind in Differenz so geschaltet, daß das magnetische Feld der Erde weitgehend kompensiert wird. Ein in der Nähe des Magnetometers befindliches ferromagnetisches Teil bewirkt eine Störung des magnetischen Erdfeldes bzw. das Eigenfeld des ferromagnetischen Teils überlagert sich dem Erdfeld. Durch Annäherung der Magnetometersonde an das ferromagnetische Teil sowie durch den räumlichen Abstand der Induktoren zueinander entsteht nach Betrag und Richtung ein elektrisches Differenzsignal, das optisch und akustisch zur Anzeige gelangt.

Derartige Magnetometersonden sind sehr empfindlich; sie lösen etwa den einhunderttausendsten Teil der Totalintensität des Erdfeldes auf und sind damit in der Lage, Differenzfeldstärken im Nanotesla-Bereich und damit auch tiefliegende ferromagnetische Teile, wie beispielsweise versteckte Bomben, nachzuweisen. Wesentliche Voraussetzungen für das Erreichen einer derartigen Empfindlichkeit sind die sog. Parallelisierung sowie der elektrische Abgleich der Induktoren.

Insbesondere die mechanische Parallelisierung der beiden Induktoren verlangt eine Genauigkeit von etwa 1/100 Grad, so daß die Induktoren die gleiche Lage im Raum einnehmen müssen, damit die vom magnetischen Feld der Erde ausgeübten Induktionen auf den jeweiligen Induktor um den gleichen Betrag entgegengesetzt gleich sind.

Bei einer gattungsgemäßen Magnetometersonde sind beide Induktoren im rohrförmigen Sondengehäuse mittels einer an einem Ende des jeweiligen Induktors vorgesehenen Gelenkverbindung schwenkbar gelagert und weisen am jeweiligen anderen Ende einen von außen justierbaren Schneckentrieb auf, der zur Durchführung der Parallelisierung betätigbar ist. Für einfache, relativ unempfindliche Magnetometersonde sind auch fest fixierbare Parallelisierungseinrichtungen bekannt.

Bei den mittels zweier Schneckentriebe verstellbaren gattungsgemäßen Magnetometersonden ist die Parallelisierung für Unkundige sehr schwierig, wenn nicht gar unmöglich durchführbar, insbesondere wenn die Induktoren stark dejustiert sind und keine Bezugspunkte für einen Vorabgleich gegeben sind, denn eine wechselweise Justierung des ersten und des zweiten Induktors muß notwendigerweise bis zu einem Punkt durchgeführt werden, in dem sich die gewünschte Parallelität der Lage im Raum mit ausreichender Genauigkeit einstellt.

Weiterhin sind derartige Magnetometersonden mit insbesondere kugelartigen Gelenken sowie mit schneckenartigen Feinstgewinden mechanisch sehr aufwendig und damit sehr teuer. Darüber hinaus müssen beim Bau einer derartigen Magnetometersonde alle Teile mechanisch vermessen werden und zu einem Sondeneinsatz selektiert werden.

Aus der DE-25 25 751 ist eine Magnetometersonde bekannt, bei der die beiden Induktoren jeweils mit einer Verstelleinrichtung versehen sind, die eine Verschwenkung der beiden Induktoren relativ zum Magnetometergehäuse um zueinander rechtwinklig verlaufende Querachsen des Magnetometergehäuses gestatten. Die Verstelleinrichtungen weisen einen aufwendigen Aufbau auf und sind daher auch teuer in der Herstellung. In der US-3,961,245 wird eine Magnetometersonde mit einem beweglichen Kern aus magnetisierbarem Material beschrieben. Im Rahmen des Abgleichs der Anordnung wird das gesamte Gehäuse mit dem Induktorenaufbau um eine Achse senkrecht zur Richtung des Erdmagnetfeldes gedreht. Dabei wird ein aufgrund eines eventuellen Abgleichfehlers der Induktoren verbleibendes Signal ermittelt. Die Induktoren sind fest mit dem Gehäuse verbunden. Die GB 2 078 968 A betrifft eine Sondenanordnung mit zwei längs in einem Sondengehäuse angeordneten Induktoren. Zur Kompensation einer Fehlausrichtung der Induktoren zueinander kann ein Kern aus leicht magnetisierbarem Material, welcher in einer Kappe an einem Ende des Gehäuses angeordnet ist, senkrecht zur Längsrichtung des Gehäuses verschoben werden.

Eine Kompensation einer eventuellen Fehlausrichtung eines Magnetfeldgradiometers wird gemäß der US-A-2,996,663 durch eine Kombination einer flexiblen Induktoraufhängung innerhalb des Gehäuses und einer Verstelleinrichtung an den Gehäuseenden mit senrecht zur Gehäuselängsachse angeordneten Verstellschrauben bewerkstelligt. Aus der DE-A-29 29 404 ist es bekannt, bei magnetischen Differenzfeldsonden mit hintereinander oder nebeneinander in einem Gehäuse angeordneten Induktoren eine Kompensation durch Einbringen von Weicheisenstücken in die Nähe einer der Induktoren zu erreichen. Die US-A-3,757,209 offenbart eine ähnliche Differenzfeldsonde, bei der in einem längs des Gehäuses verschiebbaren Ring in radialer Richtung ein Stift aus leicht magnetisierbarem Material eingebracht ist. Eine Kompensation wird durch Verschieben und Drehen des Ringes auf dem Gehäuse erreicht. Den Kompensationsvorrichtungen, die auf der Wirkung eines in die Nähe eines der Induktoren gebrachten Körpers aus leicht magnetisierbarem Material beruhen, haftet der Nachteil an, daß die Magnetisierung dieser Stoffe in nicht vernachlässigbarem Maße temperaturabhängig ist. Es trifft somit beim Einsatz im Gelände häufig eine Dejustage infolge von Temperaturänderungen auf. Die Kompensationsanordnungen, die auf der Verschwenkbarkeit mindestens eines der Induktoren beruhen, haben eine nicht sehr hohe Genauigkeit. Um die geforderte Kompensationsgenauigkeit zu erreichen, muß eine Feinheit der Einstellung des Schwenkwinkels ermöglicht sein, die selbst mit äußerst aufwendigen Verstelleinrichtungen nicht ohne weiteres erreicht wird.

**Aufgabe** der vorliegenden Erfindung ist es, eine gattungsgemäße Magnetometersonde derart auszubilden, daß sie leicht und kostengünstig zu fertigen ist und bereits in der Fertigung einfach vorkalibrierbar ist und eine einfach durchzuführende Nachjustierung gestattet. Eine weitere Aufgabe besteht darin, ein Verfahren zum Abgleichen einer derartigen Magnetometersonde zu schaffen.

Die erste Aufgabe wird gemäß dem Patentanspruch 1 gelöst.

Durch die Kombination der Verschwenkbarkeit und der Verdrehbarkeit des Induktors bzw. der Induktoren wird eine einfach abgleichbare Anordnung der Magnetometersonde geschaffen, da das Verdrehen eines Induktors sowie das Verschwenken desselben oder des anderen Induktors eine wirkungsvolle parallele Ausrichtung beider Induktoren gestattet.

Prinzipiell können bei der Magnetometersondenanordnung zwei Abgleicharten, die miteinander verkettet sind, unterschieden werden.
Dies ist einerseits die Parallelisierung und andererseits der "Schaukelabgleich".
Bei der Parallelisierung wird die räumlich Lage der beiden Induktoren so ausgerichtet, daß die vom Erdfeld in den Induktoren induzierten Spannungen entgegengesetzt gleich sind. Der vollständige Schaukelabgleich erfolgt dann üblicherweise durch elektrische Symmetrierung der beiden Induktorwicklungen.

Es kann hierbei in der vorteilhaften Ausgestaltung mit zwei axial verschiebbaren, metallenen, äußeren Kurzschlußringen bereits von außen die Impedanz der beiden Induktorwicklungen so symmetriert werden, daß auch ohne elektrische Einstellung ein nahezu vollständiger Schaukelabgleich - bei guter Parallelisierung - möglich ist.
Die Ausgestaltung des metallenen, rohrförmigen Sondengehäuses mit zwei gegenüberliegenden, längs verlaufenen Schlitzen, bewirkt, daß zum einen die Wirbelstromverluste und die Temperaturkoeffizientenwerte absinken. Zum anderen wird dadurch auch erreicht, daß mittels der Kurzschlußringe wieder stärker in den elektrischen Abgleich eingegriffen werden kann.

Verbessert wird diese Abgleichbarkeit auch durch das im Anspruch 2 angegebene Merkmal, gemäß dem beide Induktoren unabhängig voneinander um die Achse des Sondengehäuses schwenkbar gelagert sind.

Die Ausgestaltung nach Anspruch 3 gestattet ein einfaches Verschwenken des ersten Induktors, da dieser Induktor zum Verschwenken an seinem freien Ende bewegt werden kann.

Die Ausgestaltung gemäß Anspruch 4 gestattet nicht nur eine einfache Fertigbarkeit der Magnetometersonde, sondern außerdem eine zuverlässige Verdrehbarkeit der Induktoren und bewirkt einen Schutz der Induktoren gegen mechanische äußere Einflüsse.

Die gleichen Vorteile besitzt auch die Ausgestaltung gemäß Anspruch 5, wobei gleichzeitig ein kompakter Aufbau des dreh- und schwenkbaren Induktors gegeben ist. Insbesondere vorteilhaft ist dabei die Aufhängung des schwenkbaren Induktors an einem Bronzedraht gemäß Anspruch 6.

Das Vorsehen einer die Schwenkbewegung beaufschlagenden Justiervorrichtung für den schwenkbaren Induktor gemäß Anspruch 7 gestattet ein zuverlässiges Einstellen der gewünschten Verschwenkung, wobei insbesondere die Ausgestaltungen gemäß Anspruch 9 oder Anspruch 10 vorteilhafte Justiervorrichtungen angeben.

Das Vorsehen von Anzeigeeinrichtungen gemäß Anspruch 8 und/ oder Anspruch 11 ist sowohl für die grobe Voreinstellung als auch für die Feinjustierung der Magnetometersonde von Vorteil, wobei eine einfache Möglichkeit des Vorsehens von Anzeigeeinrichtungen das Vorsehen einer Skala mit einem zugehörigen Bezugspfeil ist.

Die Ausgestaltung des Sondengehäuses aus einem Kunststoffmaterial gemäß Anspruch 12, insbesondere aus einem hochfesten Verbundkunststoff, wie einem glasfaserverstärkten Kunststoff, oder einem kohlefaserverstärkten Kunststoff besitzt den Vorteil eines geringen Gewichtes, wohingegen die Ausgestaltung des Sondengehäuses aus einem nichtmagnetischen Metall, vorzugsweise aus Aluminium, gemäß Anspruch 13 kostengünstiger zu fertigen ist.

Vorteilhaft für die Fertigung ist ebenfalls die Ausgestaltung gemäß Anspruch 14, wobei der Kunststoffeinsatz aus einer oder mehreren Kunststoffbuchse(n) bestehen kann, die an ihrer Innenseite als Lager für einen verdrehbaren Induktor bzw. Induktoreinsatz dient bzw. dienen.

Ein wesentlicher Vorteil der Ausbildung eines Kunststoffeinsatzes zur Aufnahme des Induktorhalters in einem Metallrohr liegt auch darin, daß die Wirbelstromeffekte reduziert werden. Diese Reduzierung der Wirbelstromeffekte kann dadurch erreicht werden, daß ein größeres Außen-Metallrohr mit dünnerer Wandstärke verwendet wird. Darüber hinaus wird durch den Kunststoffeinsatz und insbesondere seine große Fläche ein Gleitsitz für den Induktorhalter erreicht.

Besonders zweckmäßig ist eine Konstruktion, bei der in der Außenfläche des Induktorhalters, über seine Längserstrekkung verteilt, zwei oder mehr O-Ringe, zum Beispiel in Nuten vorgesehen sind, die eine zentrische Führung des Induktorhalters gestatten.
Die O-Ringe gestatten eine völlig spielfreie und zentrische Führung des Induktorhalters. Zum anderen jedoch kann aber auch dadurch die Passung zwischen Induktorhalter und dem Sondengehäuse bzw. einer dazwischen vorgesehen Buchse, etwas größer toleriert werden, da die O-Ringe das eventuell entstehende Spiel völlig aufnehmen können. Weiterhin entspannen die O-Ringe diesen spielfreien Sitz so, daß eine hohe mechanische Langzeitkonstanz in der Parallelisierung entsteht.

Das Vorsehen metallener Kurzschlußringe gemäß Anspruch 15 bzw. Anspruch 16 schafft eine steuerbare Gegeninduktivität, die eine besonders starke Wirkung bei einem Sondengehäuse aus Kunststoff entwickelt, jedoch auch bei einem Sondengehäuse aus einem nichtmagnetischen Metall Wirkung zeigt. Durch Verschieben dieser Kurzschlußringe ist ein äußerer Feinabgleich der Magnetometersonde möglich. Die bei der Ausführung des Sondengehäuses aus Metall gemäß Anspruch 13 durch die von der Sondenwicklung induzierten Wirbelströme im metallenen Sondengehäuse entstehende Gegeninduktivität bewirkt, daß die äußeren Kurzschlußringe bei dieser Ausführung nur eine verhältnismäßig geringe Einflußmöglichkeit schaffen.

Die Ausgestaltung einer Magnetometersonde gemäß Anspruch 17 mit einem metallenen rohrförmigen Sondengehäuse, welches im Bereich der Induktoren zumindest zwei in Längsrichtung des Sondengehäuses verlaufende Schlitze aufweist, ist bereits für sich allein zuverlässig justierbar und weist eine hohe zeitliche Stabilität einer erfolgten Justierung auf. Die Längsschlitze bewirken dabei eine Unterbrechung des Wirbelstromflusses im metallenen Sondengehäuse, wodurch die Gegeninduktivität und die dämpfende Wirkung verringert werden. Die mit einer Temperaturänderung einhergehende Änderung des elektrischen Widerstandes des rohrförmigen Sondenhäuses wird durch das Vorsehen der Schlitze kompensiert, wobei insbesondere eine Einstellung dieser Kompensation durch Längsverschiebung der Kurzschlußringe möglich ist.

Eine auf einer Temperaturdrift beruhende Instabilität bei Verwendung eines metallenen Sondengehäuses kann auf diese Weise vermieden werden.

Das im Anspruch 22 angegebene Verfahren zum Abgleich einer erfindungsgemäßen Magnetometersonde kann bereits nach der Fertigung der Magnetometersonde, vor der Auslieferung, zum Zwecke eines groben Vorabgleichs durchgeführt werden, wobei die Einfachheit des Verfahrens eine problemlose Integration in den Fertigungsprozeß zuläßt. Die Weiterbildungen dieses Verfahrens gemäß der Ansprüche 23 und 24 schaffen bereits bei der Fertigung bzw. beim ersten Abgleichen der Magnetometersonde eine zuverlässige Grundlage für spätere Feinbzw. Nachabgleichungen, für die dann im Regelfall nur noch der letzte Schritt des Anspruchs 22 durchgeführt werden muß. Eine zusätzliche vorteilhafte Abgleichmöglichkeit verschafft der Verfahrensschritt des Anspruchs 25.

Die Erfindung wird nachfolgend anhand einiger Beispiele unter Bezugnahme auf die Zeichnung näher erläutert; in dieser zeigt:
- Fig. 1: eine teilweise geschnittene Seitenansicht einer Anordnung einer erfindungsgemäßen Magnetometersonde,
- Fig. 2: eine ungeschnittene Seitenansicht einer weiteren Ausführung einer Sondenanordnung,
- Fig. 3: eine Stirnansicht einer Magnetometersonde gemäß der Erfindung aus Richtung III,
- Fig. 4: eine Ansicht und einen axialen Schnitt durch ein Sondengehäuse einer weiteren Ausführungsform, die allein im mittleren Bereich ein metallenes Rohr und beidseitig dazu ein aufgebrachtes Kunststoffrohr aufweist, und
- Fig. 5: eine Ansicht eines Sondengehäuses mit ähnlichem Aufbau wie nach Fig. 4.

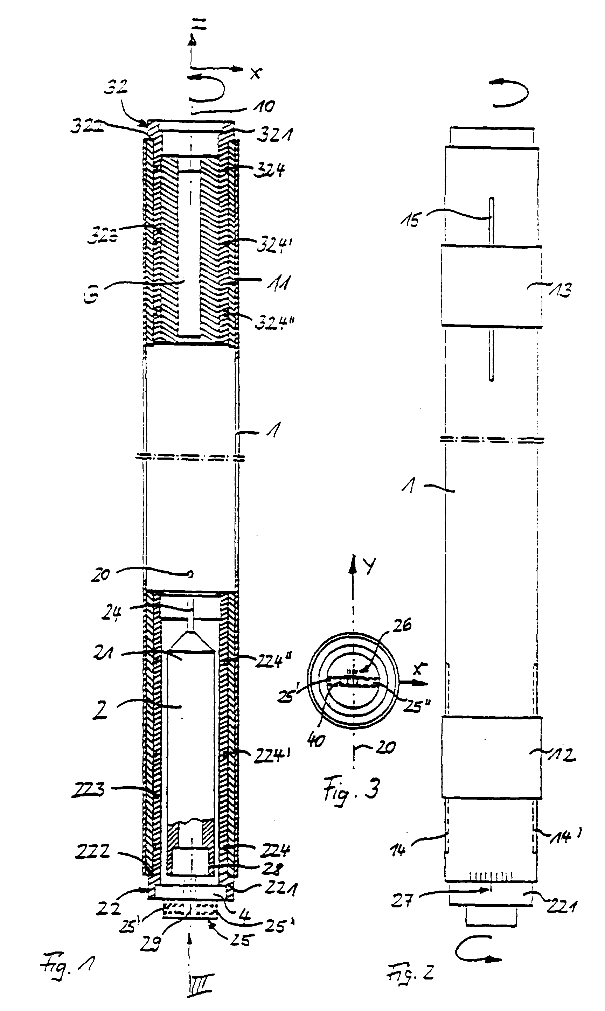

In Fig. 1 ist eine Sondenanordnung einer Magnetometersonde bzw. eines Magnetometers gemäß der Erfindung in teilweise geschnittener Ansicht dargestellt. Die Sondenanordnung weist ein rohrförmiges Sondengehäuse 1 auf, in das eine Kunststoffhülse 11 eingesetzt ist. Alternativ dazu kann das Sondengehäuse 1 im Bereich seiner freien offenen Enden jeweils auch mit einer eingesetzten Kunststoffbuchse versehen sein.

Der Kunststoffeinsatz 11 (Hülse oder Buchse) weist an jedem der beiden offenen Enden des Sondengehäuses 1 eine Bohrung auf, die koaxial zum rohrförmigen Sondengehäuse 1 verläuft und zur Aufnahme eines Induktorhalters 22, 32 dient, dessen Außenumfang an den Innenumfang des Kunststoffeinsatzes 11 im Bereich der zugeordneten Bohrung angepaßt ist. Jeder Induktorhalter 22, 32 besitzt an einem Ende einen Abschnitt erweiterten Durchmessers 221, 321, der unter Ausbildung einer radialen kreisringförmigen Stirnfläche 222, 322 in den Abschnitt 223, 323 mit an den Innendurchmesser des Kunststoffeinsatzes 11 angepaßtem geringeren Durchmesser übergeht.

Der Bereich 223, 323 geringeren Durchmessers ist an seinem Außenumfang mit zumindest zwei voneinander beabstandeten Umfangsnuten versehen, in die O-Ringe 224, 224', 224'', 324, 324', 324'' eingesetzt sind. Die O-Ringe sorgen durch ihre Eigenspannung bzw. den aufgrund ihrer Eigenspannung entstehenden Flächendruck für einen saugenden, spielfreien Sitz im Kunststoffeinsatz 11 und damit im Sondenrohr 1.

Durch Beifügen eines geeigneten Langzeitschmierfetts, wie z.B. Silikonpaste, beim Einsetzen der Induktorhalter 22, 32, wird ein spielfreies Drehen der Induktorhalter 22, 32 und damit auch der in den Induktorhaltern koaxial angeordneten jeweiligen Induktoren 2, 3, um die Achse 10 des Sondengehäuses 1 gewährleistet.

Der Induktor 2, 3, der vorzugsweise ein aus einem Magnetstreifen mit Primär- und Sekundärwicklung bestehendes magnetempfindliches Element ist, ist zentrisch im Induktorhalter und damit koaxial zur Achse 10 des Sondengehäuses 1 angeordnet. Der zweite (in Fig. 1 obere) Induktorhalter 32 nimmt den zugeordneten Induktor 3 derart auf, daß dieser eine koaxiale feste Lage einnimmt, jedoch um seine eigene Achse, und damit um die Achse 10 des Sondengehäuses, drehbar ist. Der erste (in Fig. 1 untere) Induktorhalter 22 ist als Hohlkörper ausgebildet, der den Induktor 2 schwenkbar aufnimmt. Der Induktor 2 ist dabei an seinem dem zweiten Induktor 3 zugewandten Ende 21 mit einem Bronzedraht 24 verbunden, welcher wiederum zentrisch mit dem Induktorhalter 22 verbunden ist, so daß sich für den Induktor 2 eine zentrische Aufhängung ergibt.

Am vom zweiten Induktor 3 wegweisenden (in Fig. 1 unteren) Ende 28 des schwenkbaren Induktors 2 steht ein zentrales Achsstück 29 axial aus dem Induktor 2 hervor. Das freie Ende dieses Achsstücks 29 greift in einen rechtwinklig zur von der Achse 10 des Sondengehäuses 1 und der Schwenkachse 20 gebildeten Ebene angeordneten Längsschlitz 40 eines den ersten Induktorhalter 22 an seinem freien Ende verschließenden Deckelteils 4 ein, so daß sich das Achsteil 29 beim Schwenken des Induktors 2 entlang des Längsschlitzes 40 bewegt.

Im Längsschlitz 40 bzw. in zu dem Längsschlitz 40 im wesentlichen parallel verlaufenden Gewindebohrungen sind Justierschrauben 25', 25'' eingesetzt, mittels derer einerseits ein Verschieben des Achsteils 29 im Längsschlitz 40 und damit ein Verschwenken des Induktors 2 bewirkt werden kann und andererseits der Induktor 2 über ein Arretieren des Achsteils 29 im Längsschlitz 40 in seiner Schwenkposition fixiert werden kann. Anstelle der Schrauben 25', 25'' kann auch nur eine Schraube vorgesehen sein, wobei die gegenübergelegene andere Schraube durch eine Druckfeder ersetzt ist.

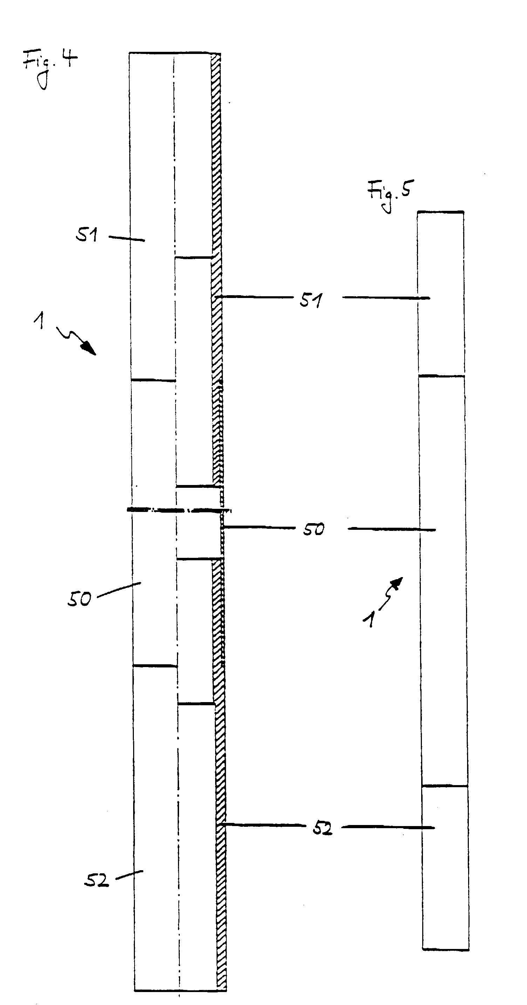

Das Achsstück 29 ist an seiner Stirnseite mit einer Markierung versehen, die mit einer Skaleneinteilung an der Stirnseite des Deckelteils 4 als Anzeigeeinrichtung 26 für den Schwenkwinkel des Induktors 2 wirkt (Fig. 3). Eine weitere Markierung ist am Außenumfang des Abschnitts 221 größeren Durchmessers des ersten Induktorhalters 22 vorgesehen (Fig. 2) . Diese Markierung wirkt mit einer dieser benachbart gelegenen Skaleneinteilung am Außenumfang des Sondengehäuses 1 zusammen und bildet eine Anzeigeeinrichtung 27 für den Verdrehwinkel des ersten Induktors 2 um die Achse 10 des Sondengehäuses.

Das Sondengehäuse 1 kann sowohl aus Nichteisenmetall, vorzugsweise aus dünnem, hochfesten Aluminium, als auch aus einem hochfesten Verbund-Kunststoff, wie glasfaser-verstärktem Kunststoff oder kohlefaserverstärktem Kunststoff bestehen. Bei der Metallausführung werden im metallenen rohrförmigen Sondengehäuse 1 von der Sondenwicklung ausgehend Wirbelströme im Sondengehäuse 1 induziert, die eine starke Gegeninduktivität verursachen. Durch eine Änderung der Temperatur wird eine Veränderung des elektrischen Widerstands des metallenen Sondengehäuses bewirkt, so daß eine Temperaturdrift in der Sondenanordnung auftreten kann, die zu einer Instabilität der Messungen führt. Aus diesem Grund ist das metallene Sondenrohr 1 im Bereich der Induktoren 2, 3 mit Längsschlitzen 14, 14', 15 versehen, wobei jedem Induktor zwei radial gegenübergelegene Schlitze 14, 14' zugeordnet sind.

Die beiden Längsschlitze 14, 14' des ersten Induktors 2 sind um 90° um die Achse 10 des Sondengehäuses 1 gegenüber den Längsschlitzen 15 des zweiten Induktors verdreht angeordnet. Es können jedem Induktor auch mehr als zwei Längsschlitze zugeordnet sein. Mittels der Längsschlitze 14, 14', 15 wird der Wirbelstrom im metallenen rohrförmigen Sondengehäuse 1 unterbrochen, so daß die vom Wirbelstrom verursachte Gegeninduktivität beeinflußbar ist. Durch die Schlitzlänge kann die Gegeninduktivität des Sondenrohres 1 so verändert werden, daß sich die Temperaturkoeffizienten an beiden Induktorpositionen kompensieren.

Auf diese Weise kann durch die Wahl der jeweiligen Schlitzlänge der Temperaturgang der Induktoren nahezu vollständig kompensiert werden.

Im Bereich der Induktoren 2, 3 sind das Sondengehäuse 1 umgreifende metallene Kurzschlußringe 12, 13 vorgesehen, die bezüglich des Sondengehäuses 1 längsverschieblich angeordnet sind, wozu die Kurzschlußringe ein Innengewinde aufweisen können, das mit einem Außengewinde des Sondengehäuses 1 zusammenwirkt. Diese außen am Sondengehäuse 1 verschiebbar angeordneten, metallenen Kurzschlußringe bilden eine steuerbare Gegeninduktivität, die insbesondere bei einem aus Kunststoff bestehenden Sondengehäuse eine besonders starke Wirkung zeigt. Aber auch in der Ausführung mit einem geschlitzten, metallenen Sondengehäuse kann die im Bereich der Schlitze verringerte Gegeninduktivität mittels der Kurzschlußringe lokal gezielt erhöht werden, um eine Justierung vorzunehmen.

Die hinreichend bekannte Auswerte- und Anzeigelektronik beider Induktoren 2,3 ist im mittleren Bereich des rohr- oder stabförmigen Sondengehäuses untergebracht.

Durch Drehen des ersten Induktors 2 um die Achse 10 (Z-Achse) und Schwenken um die Achse 20 (Y-Achse) kann der Induktor 2 in Richtung der orthogonal zur Y-Z-Ebene gerichteten X-Achse verstellt werden, während der zweite Induktor 3 im Beispiel nur um die Z-Achse drehbar ist.

Der Abgleich zur Parallelisierung erfolgt entsprechend der nachfolgend aufgeführten Verfahrensschritte:

Zunächst wird die betriebsbereite Sondenanordnung an einem eisenfreien Ort drehbar um die Achse 10 des Sondengehäuses 1 aufgehängt. Ein grober Vorabgleich wird dadurch erzielt, daß der erste (untere) Induktor 2 in seine zentrale Position gebracht wird, in der die Anzeigeeinrichtung 26 eine Mittelstellung anzeigt. Im Bereich geringer Empfindlichkeit wird dann die Sonde um die eigene Achse 10 gedreht, um die Höhe der Fehlanzeige durch mangelnde Parallelisierung festzustellen.

Durch Drehung beider Induktoren 2, 3 um die Sondenachse 10 (und damit um deren jeweilige eigene Achse) wird zunächst die Fehlanzeige minimiert. Dann wird der zweite (obere) Induktor fixiert und seine Position wird markiert. Die Feinjustierung erfolgt nun lediglich am ersten (unteren) Induktor und zwar derart, daß er wechselweise um einen kleinen Betrag gedreht und/oder in Richtung der X-Achse geschwenkt wird.

Ist die optimale Parallelisierung erreicht, so wird die am Umfang des Sondenrohrs vorgesehene Skala derart angebracht, daß die auf dem Abschnitt vergrößerten Umfangs 221 vorgesehene Anzeige eine Mittelmarkierung einnimmt. Die ermittelten Skalenwerte der Anzeigeneinrichtungen 26 und 27 werden notiert und bilden die Grundlage für einen reproduzierbaren Abgleichpunkt, der in die technischen Daten des Gerätes aufgenommen wird. Auf diese Weise wird der Geräteservice erheblich vereinfacht.

Obwohl in der Beschreibung von einem Sondengehäuse mit rundem Querschnitt ausgegangen worden ist, kann das Sondengehäuse auch eine beliebige andere Querschnittsform, beispielsweise eine Rechteckform, aufweisen, wobei gegebenenfalls auch die Induktoren derart angeordnet sind, daß die Induktorachsen parallel zueinander und parallel zur Achse des Sondengehäuses ausgerichtet bzw. ausrichtbar sind.

Der Schnitt nach Fig. 4 zeigt ein weiteres, sehr vorteilhaft gestaltetes Sondengehäuse 1, das im mittleren Bereich ein Aluminiumrohr 50 aufweist, auf das beidseitig ein Kunststoffrohr 51,52 aufgebracht ist. In der Schnittdarstellung, in der rechten Hälfte der Fig. 4, ist dargestellt, daß das jeweilige Kunststoffrohr 51,52 in den Endbereich des Aluminiumrohres 50 eingesetzt ist. Hierfür eignet sich z.B. ein paßgenauer Sitz mit einer Festverklebung zwischen Aluminiumrohr 50 und Kunststoffrohr 51. Der Innendurchmesser des Kunststoffrohres 51,52 kann zum Endbereich hin nochmals gestuft, mit einem geringfügig größeren Innendurchmesser ausgebildet sein. In diesem Bereich kann dann der Induktorhalter mit Gleitsitz vorgesehen werden.

Das Beispiel nach Fig. 5 zeigt prinzipiell den gleichen Aufbau wie nach Fig. 4. Dort jedoch ist der Mittelteil des Sondengehäuses 1 als Aluminiumrohr 50 länger ausgebildet, so daß beidseitig kürzere Kunststoffrohre 51,52, z.B. von der Länge des Induktorhalters mit dem Aluminiumrohr 50 fest verbunden sind.

Diese Ausführungsformen des Sondengehäuses nach den Fig. 4 und 5 haben insbesondere den Vorteil, daß die Rohrmitte aus preisgünstigem Aluminium gemacht werden kann und die Induktorzone als komplettes Kunststoffrohr bzw. Kunststoffbüchse aufgesetzt werden kann. Hierdurch entfallen fertigungstechnisch die Herstellung der Schlitze im Metallrohr, wie sie im Beispiel nach Fig. 2 zweckmäßigerweise vorgesehen werden.

Die Ausführungsformen nach Fig. 4 und 5 zeigen daher mechanisch und konstruktiv günstig zu fertigende Sondengehäuse, die zuuem auch elektrisch, z.B. durch die Vermeidung von Wirbelströmen in der Induktorzone, hervorragende Eigenschaften haben.

## Patentansprüche

1. Magnetometersonde mit einem rohrförmigen Sondengehäuse (1), in dem voneinander beabstandet und im wesentlichen koaxial zum Sondengehäuse (1) zwei Induktoren (2, 3) angeordnet sind, wobei mindestens ein erster Induktor (2) um eine quer zur Achse (10) des Sondengehäuses (1) gelegene Achse (20) schwenkbar gelagert ist und beide Induktoren (2, 3) unabhängig voneinander um die Achse (10) des Sondengehäuses (1) drehbar gelagert sind.

2. Magnetometersonde nach Anspruch 1,
dadurch **gekennzeichnet,**
daß beide Induktoren (2, 3) unabhängig voneinander um eine zur Achse (10) des Sondengehäuses (1) senkrechte Achse schwenkbar gelagert sind.

3. Magnetometersonde nach Anspruch 2,
dadurch **gekennzeichnet,**
daß die Schwenkachse (20) des ersten Induktors (2) im Bereich des dem zweiten Induktor (3) zugewandten Endes (21) oder diesem Ende (21) benachbart gelegen ist.

4. Magnetometersonde nach einem der vorhergehenden Ansprüche,
dadurch **gekennzeichnet,**
daß zumindest einer der um die Achse (10) des Sondengehäuses (1) drehbaren Induktoren (2, 3) in einem Induktorhalter (22, 32) angeordnet ist und
daß der Induktorhalter (22, 32) im Sondengehäuse (1) um dessen Achse (10) drehbar gelagert ist.

5. Magnetometersonde nach einem der vorhergehenden Ansprüche,
dadurch **gekennzeichnet,**
daß der dreh- und schwenkbare erste Induktor (2) innerhalb eines Induktorhalters (22) schwenkbar gelagert ist
und daß der Induktorhalter (22) im Sondengehäuse (1) um dessen Achse (10) drehbar gelagert ist.

6. Magnetometersonde nach Anspruch 5,
dadurch **gekennzeichnet,**
daß der schwenkbare Induktor (2) innerhalb des Induktorhalters (22) zentrisch an einem Bronzedraht (24) schwenkbar aufgehängt ist.

7. Magnetometersonde nach einem der vorhergehenden Ansprüche,
dadurch **gekennzeichnet,**
daß der schwenkbare Induktor (2) mit einer die Schwenkbewegung beaufschlagenden Justiervorrichtung (25) versehen ist.

8. Magnetometersonde nach Anspruch 7,
dadurch **gekennzeichnet,**
daß die Justiervorrichtung (25) mit einer den Grad der Verschwenkung wiedergebenden Anzeigeeinrichtung (26) zusammenwirkt.

9. Magnetometersonde nach einem der Ansprüche 7 oder 8,
dadurch **gekennzeichnet,**
daß die Justiervorrichtung (25) zwei entgegengesetzt wirkende, den Induktor arretierende Schrauben (25', 25'') aufweist.

10. Magnetometersonde nach einem der Ansprüche 7 oder 8,
dadurch **gekennzeichnet,**
daß die Justiervorrichtung (25) eine den Induktor (2) gegen die Kraft einer Feder arretierende Schraube aufweist.

11. Magnetometersonde nach einem der vorhergehenden Ansprüche,
dadurch **gekennzeichnet,**
daß zumindest ein drehbarer Induktor (2, 3) bzw. Induktorhalter (22, 32) mit einer den Grad der Verdrehung wiedergebenden Anzeigeeinrichtung (27) zusammenwirkt.

12. Magnetometersonde nach einem der vorhergehenden Ansprüche,
dadurch **gekennzeichnet,**
daß das Sondengehäuse (1) aus einem Kunststoffmaterial besteht.

13. Magnetometersonde nach einem der Ansprüche 1 bis 11,
dadurch **gekennzeichnet,**
daß das Sondengehäuse (1) aus einem nichtmagnetischen Metall, vorzugsweise aus Aluminium, besteht.

14. Magnetometersonde nach Anspruch 13,
dadurch **gekennzeichnet,**
daß das Sondengehäuse (1) auf seiner Innenseite einen Kunststoffeinsatz (11) aufweist, der den Induktorhalter (22, 32), insbesondere saugend, aufnimmt.

15. Magnetometersonde nach einem der vorhergehenden Ansprüche,
dadurch **gekennzeichnet,**
daß im Bereich der Induktoren (2, 3) das Sondengehäuse (1) umgreifende metallene Kurzschlußringe (12, 13) angeordnet sind, die bezüglich des Sondengehäuses (1) längsverschieblich angeordnet sind.

16. Magnetometersonde nach Anspruch 15,
dadurch **gekennzeichnet,**
daß die Kurzschlußringe (12, 13) ein Innengewinde aufweisen, das zur Längsverstellung mit einem Außengewinde des Sondengehäuses (1) zusammenwirkt.

17. Magnetometersonde nach einem der Ansprüche 13 bis 16,
dadurch **gekennzeichnet,**
daß das metallene rohrförmige Sondengehäuse im Bereich der Induktoren (2, 3) zumindest zwei in Längsrichtung des Sondengehäuses (1) verlaufende Schlitze aufweist.

18. Magnetometersonde nach einem der Ansprüche 1 bis 17,
dadurch **gekennzeichnet,**
daß der Induktorhalter (22, 32) mit einer spielfreien und zentrischen Führung (224, 324) im Sondengehäuse (1) oder einem Kunststoffeinsatz (11) des Sondengehäuses (1) angeordnet ist.

19. Magnetometersonde nach Anspruch 18,
dadurch **gekennzeichnet,**
daß über die Länge des Induktorhalters (22, 32) verteilt mindestens zwei O-Ringe (224, 324) zur spielfreien Führung im Sondengehäuse (1) vorhanden sind.

20. Magnetometersonde nach einem der Ansprüche 1 bis 12,
dadurch **gekennzeichnet,**
daß das rohrförmige Sondengehäuse (1) im axial mittleren Bereich als Aluminiumrohr (50) ausgebildet ist, mit dem beidseitig ein Kunststoffrohr (51, 52) verbunden ist.

21. Magnetometersonde nach Anspruch 20,
dadurch **gekennzeichnet,**
daß das jeweilige Kunststoffrohr (51, 52) als Gleitbüchse für einen Induktorhalter (21, 32) ausgeführt und paßgenau in das Aluminiumrohr (50) eingesetzt, insbesondere verklebt, ist.

22. Verfahren zum Abgleichen einer Magnetometersonde nach einem der Ansprüche 1 bis 21,
**gekennzeichnet**
durch die folgenden Schritte:
- die Sonde wird an einem eisenfreien Ort, mit der Achse (10) des Sondengehäuses (1) in vertikaler Richtung, positioniert, wobei der schwenkbare Induktor (2) eine unverschwenkte Mittelposition einnimmt,
- die Sonde wird im Bereich geringer Empfindlichkeit lichkeit um die Achse (10) gedreht,
- beide Induktoren (2,3) werden verdreht bis eine auftretende Fehlanzeige minimiert ist,
- der zweite Induktor (3) wird fixiert, und vorzugsweise wird seine Verdrehposition markiert,
- der erste Induktor (2) wird abwechselnd verdreht und/oder verschwenkt, bis auch die verbliebene Fehlanzeige minimiert ist.

23. Verfahren nach Anspruch 22,
dadurch **gekennzeichnet**,
daß in einem weiteren Schritt die dem ersten Induktor (2) zugeordneten Anzeigeeinrichtungen (26, 27) jeweils den Bezugswert "Null" erhalten.

24. Verfahren nach einem der Ansprüche 22 oder 23,
dadurch **gekennzeichnet,**
daß ausgehend von den im Abgleich erhaltenen Werten der Anzeigeeinrichtungen (26, 27) eine Kalibrierkurve der Magnetometersonde erstellt wird.

25. Verfahren nach einem der Ansprüche 22 bis 24,
dadurch **gekennzeichnet,**
daß ein elektrischer Schaukelabgleich durch axiales Verlagern der Kurzschlußringe (12, 13) erfolgt.

## Claims

1. Magnetometer probe having a tubular probe casing (1), in which in spaced manner and substantially coaxially to said probe casing (1) are located two inductors (2, 3), at least one first inductor (2) being pivotably mounted about an axis (20) at right angles to the axis (10) of the probe casing (1) and both inductors (2, 3), independently of one another, are mounted in rotary manner about the axis (10) of the probe casing (1).

2. Magnetometer probe according to claim 1, characterized in that both inductors (2, 3), independently of one another, are pivotably mounted about an axis perpendicular to the axis (10) of-the probe casing (1).

3. Magnetometer probe according to claim 2, characterized in that the pivoting axis (20) of the first inductor (2) is located in the area of or adjacent to the end (21) facing the second inductor (3).

4. Magnetometer probe according to one of the preceding claims, characterized in that at least one of the inductors (2, 3) rotatable about the axis (10) of the probe casing (1) is placed in an inductor holder (22, 32) and that the inductor holder (22, 32), is mounted in rotary manner in the probe casing (1) about the axis (10) thereof.

5. Magnetometer probe according to one of the preceding claims, characterized in that the rotary and pivotable, first inductor (2) is pivotably mounted within an inductor holder (22) and that the inductor holder (22) is mounted in rotary manner in the probe casing (1) about the axis (10) thereof.

6. Magnetometer probe according to claim 5, characterized in that the pivotable inductor (2) is centrally, pivotably suspended on a bronze wire (24) within the inductor holder (22).

7. Magnetometer probe according to one of the preceding claims, characterized in that the pivotable inductor (2) is provided with an adjusting device (25) acting on the pivoting movement.

8. Magnetometer probe according to claim 7, characterized in that the adjusting device (25) cooperates with a display means (26) giving the degree of pivoting.

9. Magnetometer probe according to one of the claims 7 or 8, characterized in that the adjusting device (25) has two oppositely acting, inductor-locking screws (25', 25").

10. Magnetometer probe according to one of the claims 7 or 8, characterized in that the adjusting device (25) has a screw locking the inductor (2) against the tension of a spring.

11. Magnetometer probe according to one of the preceding claims, characterized in that at least one rotary inductor (2, 3) or inductor holder (22, 32) respectively cooperates with a display means (27) giving the degree of rotation.

12. Magnetometer probe according to one of the preceding claims, characterized in that the probe casing (1) is made from a plastics material.

13. Magnetometer probe according to one of the claims 1 to 11, characterized in that the probe casing (1) is made from a nonmagnetic metal, preferably aluminium.

14. Magnetometer probe according to claim 13,characterized in that on its inside the probe casing (1) has a plastics insert (11), which receives the inductor holder (22, 32), particularly in a sucking manner.

15. Magnetometer probe according to one of the preceding claims, characterized in that in the vicinity of the inductors (2, 3) are provided metal short-circuit rings (12, 13) engaging round the probe casing (1) and which are longitudinally displaceable with respect to said probe casing (1).

16. Magnetometer probe according to claim 15, characterized in that the short-circuit rings (12, 13) have an internal thread, which cooperates with an external thread of the probe casing (1) for longitudinal adjustment.

17. Magnetometer probe according to one of the claims 13 to 16, characterized in that the metal, tubular probe casing has in the vicinity of the inductors (2, 3) at least two slots running in the longitudinal direction of the probe casing (1).

18. Magnetometer probe according to one of the claims 1 to 17, characterized in that the inductor holder (22, 32) is placed with a free from play, central guide (224, 324) in the probe casing (1) or a plastics insert (11) of said probe casing (1).

19. Magnetometer probe according to claim 18, characterized in that, distributed over the length of the inductor holder (22, 32), are provided at least two 0-rings (224, 324) for the guidance being free from play in the probe casing (1).

20. Magnetometer probe according to one of the claims 1 to 12, characterized in that the tubular probe casing (1) is constructed in the axially central area in the form of an aluminium tube (50), to which is connected on either side a plastics tube (51, 52).

21. Magnetometer probe according to claim 20, characterized in that the plastics tube (51, 52) is constructed as a sliding sleeve for an inductor holder (21, 32) and is inserted, particularly bonded, in accurately fitting manner in the aluminium tube (50).

22. Method for balancing a magnetometer probe according to one of the claims 1 to 21, characterized by the following steps:
- the probe is positioned at an iron-free location with the axis (10) of the probe casing (1) in the vertical direction, the pivotable inductor (2) assuming an unpivoted mid-position,
- the probe is rotated about the axis (10) in the low sensitivity area,
- both inductors (2, 3) are rotated until an incorrect reading is minimized,
- the second inductor (3) is fixed and preferably its rotation position is marked,
- the first inductor (2) is alternately rotated and/or pivoted until the remaining incorrect reading is minimized.

23. Method according to claim 22, characterized in that in a further step the display means (26, 27) associated with the first inductor (2) are in each case given the reference value "zero".

24. Method according to one of the claims 22 or 23, characterized in that a calibration curve of the magnetometer probe is plotted based on the values of the display means (26, 27) obtained in the balancing operation.

25. Method according to one of the claims 22 to 24, characterized in that an electric rocking balance is brought about by axial displacement of the short-circuit rings (12, 13).

## Revendications

1. Sonde de magnétomètre comportant un boîtier de sonde (1) tubulaire dans lequel deux inducteurs (2, 3) sont disposés à distance l'un de l'autre de manière essentiellement coaxiale avec le boîtier de sonde (1), au moins un premier inducteur (2) étant monté pivotant autour d'un axe (20) disposé transversalement à l'axe (10) du boîtier de sonde (1) et les deux inducteurs (2, 3) étant montés de manière à pouvoir pivoter indépendamment l'un de l'autre autour de l'axe (10) du boîtier de sonde (1).

2. Sonde de magnétomètre selon la revendication 1, caractérisée par le fait que les deux inducteurs (2, 3) sont montés de manière à pouvoir basculer indépendamment l'un de l'autre autour d'un axe perpendiculaire à l'axe (10) du boîtier de sonde (1).

3. Sonde de magnétomètre selon la revendication 2, caractérisée par le fait cue l'axe de basculement (20) du premier inducteur (2) est situé dans la région de l'extrémité (21) tournée vers le deuxième inducteur (3) ou est voisin de cette extrémité (21).

4. Sonde de magnétomètre selon une des revendications précédentes, caractérisée par le fait qu'au moins un des inducteurs (2, 3) pivotant autour de l'axe (10) du boîtier de sonde (1) est disposé dans un porte-inducteur (22, 32) et par le fait que le porte-inducteur (22, 32) est monté tournant dans le boîtier de sonde (1), autour de l'axe (10) de celui-ci.

5. Sonde de magnétomètre selon une des revendications précédentes, caractérisée par le fait que le premier inducteur (2) pilotant et basculant est monté basculant à l'intérieur d'un porte-inducteur (22) et par le fait que le porte-inducteur (22) est monté tournant dans le boîtier de sonde (1) autour de l'axe (10 de celui-ci.

6. Sonde de magnétomètre selon la revendication 5, caractérisée par le fait que l'inducteur (2) basculant est suspendu avec possibilité de basculement, de manière centrale, dans le porte-inducteur (22) à l'aide d'un fil de bronze (24).

7. Sonde de magnétomètre selon une des revendications précédentes, caractérisée par le fait que l'inducteur (2) basculant est pourvu d'un dispositif de réglage (25) qui agit sur le mouvement de basculement.

8. Sonde de magnétomètre selon la revendication 7, caractérisée par le fait que le dispositif de réglage (25) coopère avec un dispositif d'affichage (26) qui indique le degré de basculement.

9. Sonde de magnétomètre selon une des revendications 7 ou 8, caractérisée par le fait que le dispositif de réglage (25) comporte deux vis (25', 25") qui agissent dans des directions opposées et bloquent l'inducteur.

10. Sonde de magnétomètre selon une des revendications 7 ou 8, caractérisée par le fait que le dispositif de réglage (25) comporte une vis qui bloque l'inducteur (2) à l'encontre de la force d'un ressort.

11. Sonde de magnétomètre selon une des revendications précédentes, caractérisée par le fait qu'au moins un inducteur (2, 3) ou un porte-inducteur (22, 32) tournant coopère avec un dispositif d'affichage (27) qui indique le degré de rotation.

12. Sonde de magnétomètre selon une des revendications précédentes, caractérisée par le fait que le boîtier de sonde (1) est réalisé en une matière plastique.

13. Sonde de magnétomètre selon une des revendications 1 à 11, caractérisée par le fait que le boîtier de sonde (1) est réalisé en un métal amagnétique, de préférence en aluminium.

14. Sonde de magnétomètre selon la revendication 13, caractérisée par le fait que le boîtier de sonde (1), sur sa face intérieure, présente une garniture (11) en matière plastique qui reçoit le porte-inducteur (22, 32) de préférence par ventouse.

15. Sonde de magnétomètre selon une des revendications précédentes, caractérisée par le fait que des bagues de court-circuit (12, 13) métalliques qui entourent le boîtier de sonde (1) sont disposées dans la région des inducteurs (2, 3), lesquelles bagues peuvent coulisser dans la direction longitudinale par rapport au boîtier de sonde (1).

16. Sonde de magnétomètre selon la revendication 15, caractérisée par le fait que les bagues de court-circuit (12, 13) présentent un filetage intérieur qui coopère avec un filetage extérieur du boîtier de sonde

17. Sonde de magnétomètre selon une des revendications 13 à 16, caractérisée par le fait que le boîtier de sonde (1) tubulaire métallique présente, dans la région des inducteurs (2, 3), au moins deux fentes qui s'étendent dans la direction longitudinale du boîtier de sonde (1).

18. Sonde de magnétomètre selon une des revendications 1 à 17, caractérisée par le fait que le porte-inducteur (22, 32) est monté à l'aide d'un moyen (224, 324) de guidage centré et sans jeu dans le boîtier de sonde (1) ou dans une garniture en matière plastique (11) du boîtier de sonde (1).

19. Sonde de magnétomètre selon la revendication 18, caractérisée par le fait qu'au moins deux joints toriques (224, 324) assurant le guidage sans jeu dans le boîtier de sonde (1) sont répartis sur la longueur du porte-inducteur (22, 32).

20. Sonde de magnétomètre selon une des revendications 1 à 12, caractérisée par le fait que le boîtier de sonde (1) tubulaire, dans sa partie médiane axiale, est réalisé sous la forme d'un tube d'aluminium (50) auquel un tube en matière plastique (51, 52) est liée de chaque côté.

21. Sonde de magnétomètre selon la revendication 20, caractérisée par le fait que le tube en matière plastique (51, 52) concerné est conformé en douille de glissement pour un porte-inducteur (21, 32) et est monté ajusté dans le tube d'aluminium (50), notamment est collé.

22. Procédé d'équilibrage d'une sonde de magnétomètre selon une des revendications 1 à 21, caractérisé par les étapes suivantes:
- on positionne la sonde dans un endroit ne comportant pas de fer avec l'axe (10) du boîtier de sonde (1) dirigé verticalement, l'inducteur basculant (2) prenant une position médiane non basculée,
- on fait tourner la sonde autour de l'axe (10) pour l'amener dans la zone de faible sensibilité.
- on tourne les deux inducteurs (2, 3 ) jusqu'à ce qu'une erreur affichée soit minimale,
- on bloque le deuxième inducteur (3) et de préférence on repère sa position angulaire;
- on tourne et on fait pivoter alternativement le premier inducteur (2) jusqu'à ce que l'erreur restante soit minimale.

23. Procédé selon la revendication 22, caractérisé par le fait qu'au cours d'une étape supplémentaire les dispositifs d'affichage (26, 27) associés au premier inducteur (2) reçoivent la valeur de référence "zéro".

24. Procédé selon une des revendications 22 ou 23, caractérisé par le fait qu'à partir des valeurs des dispositifs d'affichage (26, 27) obtenues au cours de l'équilibrage on établit une courbe d'étalonnage de la sonde de magnétomètre.

25. Procédé selon une des revendications 22 ou 24, caractérisé par le fait que l'on effectue une compensation électrique de dérive par déplacement axial des bagues de court-circuit (12, 13).
